# EUROPEAN PATENT APPLICATION

(11) **EP 1 746 792 A1**
(43) Date of publication of application: **24.01.2007**
(21) Application number: 05737123.9
(22) Date of filing: 26.04.2005
(51) Int. Cl.: H04L 27/22, H04L 27/38, H04B 7/08, H03M 13/25

(54) **RADIO COMMUNICATION APPARATUS AND RADIO COMMUNICATION SYSTEM**

(30) Priority: 11.05.2004 JP 2004140969
(71) Applicant: Matsushita Electric Industrial Co., Ltd., Kadoma-shi Osaka 571-8501 (JP)
(72) Inventor: MIYOSHI, Kenichi., c/o Matsushita El.Ind.Co.Ltd, Osaka 540-6319 (JP); NISHIO, Akihiko., c/o Matsushita El.Ind.Co.Ltd, Osaka 540-6319 (JP)
(74) Representative: Grünecker, Kinkeldey, Stockmair & Schwanhäusser Anwaltssozietät
(86) International application number: PCT/JP2005/007902
(87) International publication number: WO 2005/109811

(57) **Abstract**

A radio communication apparatus that can more precisely grasp, in a case of using a plurality of antenna elements to receive radio signals, the reception qualities of the respective antenna elements to improve the error rate of received signals. In the apparatus, a lower-order bit likelihood extracting part (107) extracts, based on a multi-level modulation scheme of data (ch) notified by a modulation scheme determining part (106), the likelihood of LSB only or the likelihood of LSB to two bits from all bit likelihood received from a bit likelihood calculating part (104), and then inputs the extracted likelihood to a distribution calculating part (108), which is then calculates the distribution of the likelihood for each antenna element.

## Description

### Technical Field

The present invention relates to a radio communication apparatus and radio communication system.

### Background Art

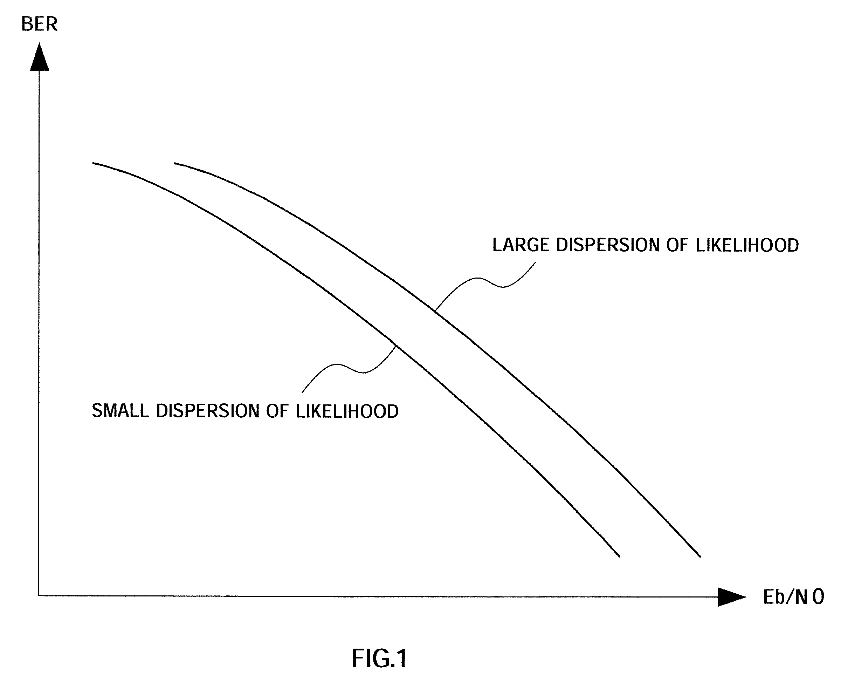

Conventionally, antenna selective diversity techniques have been known where an antenna element with small fluctuations in reception electric field strength is selected from a plurality of antenna elements to be used (for example, see Patent Document 1). In the antenna selective diversity technique as described in Patent Document 1, an antenna element to be used is selected using a bit error rate characteristic of a received signal as shown in FIG.1. FIG.1 is a graph showing the relationship between a ratio (Eb/NO) of power per bit of a received signal to noise power and a BER (Bit Error Rate). The received signal is demodulated and subjected to hard decision by the maximum likelihood method, and in accordance with a decrease of the dispersion in likelihood per bit of the received signal used in hard decision, the error rate of the received signal decreases, as shown in FIG. 1. In other words, in the antenna selective diversity technique as described in Patent Document 1, by selecting an antenna element with small fluctuations in reception electric field strength, that is, by selecting an antenna element with small dispersion of the likelihood per bit of the received signal, the error rate of the received signal is improved.
Patent Document 1: Japanese Patent Application Laid-Open No .2001-244860

### Disclosure of Invention

### Problems to be Solved by the Invention

However, in the antenna selective diversity technique as described in Patent Document 1, targets are received signals subjected to Phase Shift keying (PSK), Quadrature Phase Shift Keying (QPSK), Differential Phase Shift Keying (DPSK) or Differential Quadrature Phase Shift Keying (DQPSK), and a problem arises that the error rate cannot be improved in received signals subjected to PSK with eight or more values or Quadrature Amplitude Modulation (QAM) with sixteen or more values. This problem will specifically be described using 16QAM as an example.

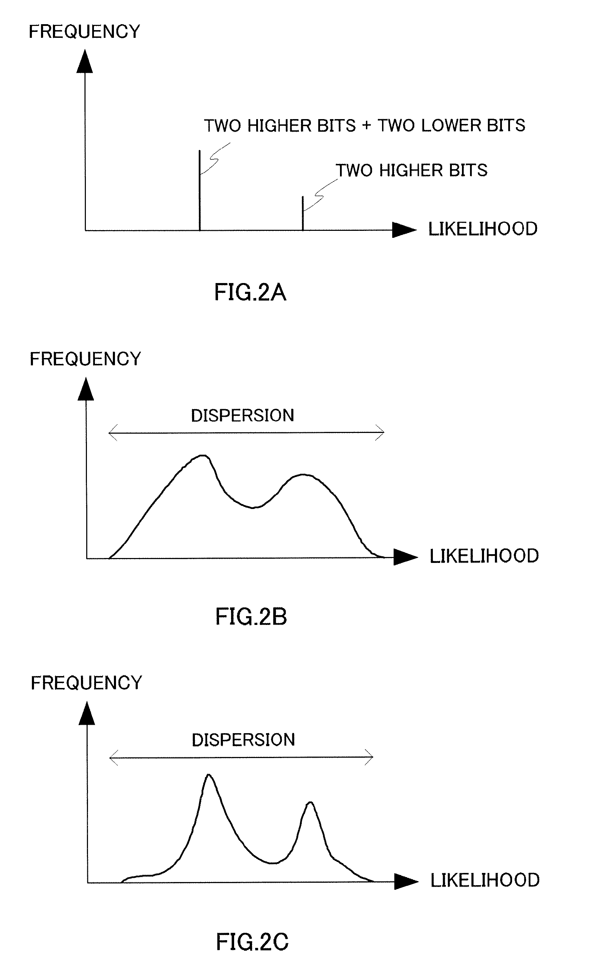

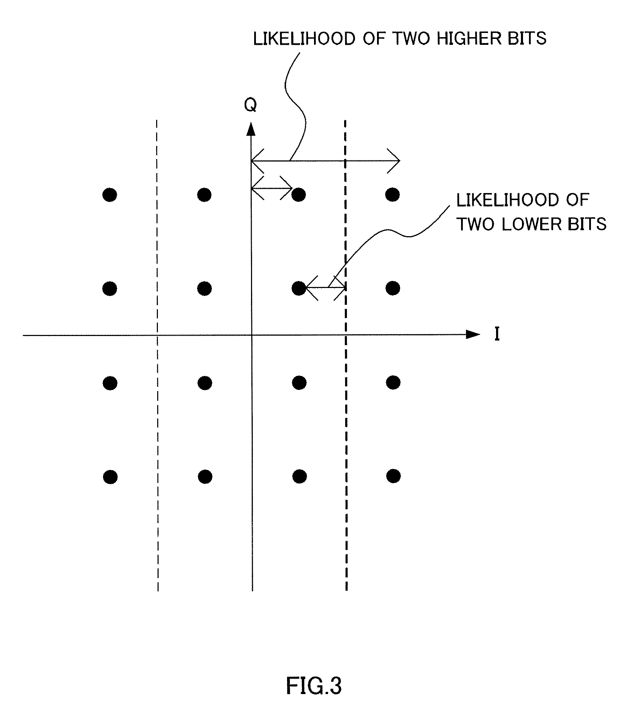

FIGs.2A to 2C show distribution modes of the likelihood of one symbol of a received signal modulated with 16QAM. FIG.2A shows a distribution mode of the likelihood of the received signal in an ideal reception state that noise, interference signals and delay versions are not included in the received signal at all. As can be seen from FIG.2A, even in such an ideal reception state, two peaks are formed in the distribution mode of the likelihood in the received signal modulated with 16QAM. The reason why two peaks are formed is that since a received signal modulated with 16 QAM is made up of four bits, references to calculate the likelihood are different between two higher bits and two lower bits. To be more specific, as illustrated in FIG.3 showing a constellation of the received signal modulated with 16QAM, the likelihood of two higher bits of the received signal is expressed by a distance from an I axis or Q axis, while the likelihood of two lower bits is expressed by a distance from a center line dividing each quadrant of four quadrants in IQ quadrature coordinates. In addition, for simplicity, FIG.3 shows the likelihood only on the Q axis.

In the antenna selective diversity technique as described in Patent Document 1, since fluctuations in reception electric field strength are measured, likelihood and dispersion of the likelihood are naturally calculated on a symbol basis of the received signal. As a result, in the antenna selective diversity technique as described in Patent Document 1, for example, in the case of using a radio reception apparatus provided with two antenna elements, the likelihood of the received signal by antenna element 1 is observed in the distribution mode as shown in FIG.2B, and similarly, the likelihood of the received signal by antenna element 2 is observed in the distribution mode as shown in FIG. 2C. Accordingly, in the antenna selective diversity technique as described in Patent Document 1, since two peaks originally exist in the distribution mode of the likelihood of the received signal, the dispersion of the likelihood spreads.
Therefore, it becomes difficult to accurately obtain the reception quality for each antenna element, and as a result, it becomes difficult to improve the error rate of the received signal.

It is therefore an object of the present invention to provide a radio communication apparatus and radio communication system capable of obtaining reception quality for each antenna element more accurately, and improving an error rate of a received signal, when a radio signal is received at a plurality of antenna elements.

### Means for Solving the Problem

A radio communication apparatus of the present invention adopts a configuration provided with: a plurality of antenna elements : a calculating section that calculates the dispersion of the likelihood for each of the plurality of antenna elements on a part of lower bits of a signal received at each of the plurality of antenna elements; and a selecting section that selects the antenna elements in ascending order of the dispersion.

### Advantageous Effect of the Invention

According to the present invention, when a radio signal is received at a plurality of antenna elements, it is possible to prevent the dispersion of the likelihood from spreading, and as a result, obtain the reception quality for each antenna element more accurately.
Accordingly, it is possible to improve the error rate of the received signal.

### Brief Description of Drawings

FIG.1 is a graph showing a bit error rate characteristic of the received signal;
FIG.2A is a graph showing a distribution mode of the likelihood of the received signal modulated with 16QAM (ideal state);
FIG.2B is a graph showing a distribution mode of the likelihood of the received signal modulated with 16QAM (antenna element 1);
FIG.2C is a graph showing a distribution mode of the likelihood of a received signal modulated with 16QAM (antenna element 2);
FIG.3 shows a constellation of the received signal modulated with 16QAM;
FIG.4 is a block diagram showing a configuration of a radio communication apparatus according to an embodiment of the present invention;
FIG.5 shows an example of a frame configuration of a radio signal used in the embodiment of the present invention;
FIG.6 shows bit configurations of the received signal used in the embodiment of the present invention;
FIG.7A is a graph showing a distribution mode of the likelihood of two lower bits of the received signal in the embodiment of the present invention (ideal state) ;
FIG.7B is a graph showing a distribution mode of the likelihood of two lower bits of the received signal in the embodiment of the present invention (antenna element 101-1);
FIG.7C is a graph showing a distribution mode of the likelihood of two lower bits of the received signal in the embodiment of the present invention (antenna element 101-2);
FIG.8 is a table showing simulation results of antenna element selection in the embodiment of the present invention (in selecting one antenna element); and
FIG.9 is a table showing simulation results of antenna element selection in the embodiment of the present invention (in selecting three antenna elements).

### Best Mode for Carrying Out the Invention

An embodiment of the present invention will be described below in detail with reference to the accompanying drawings.

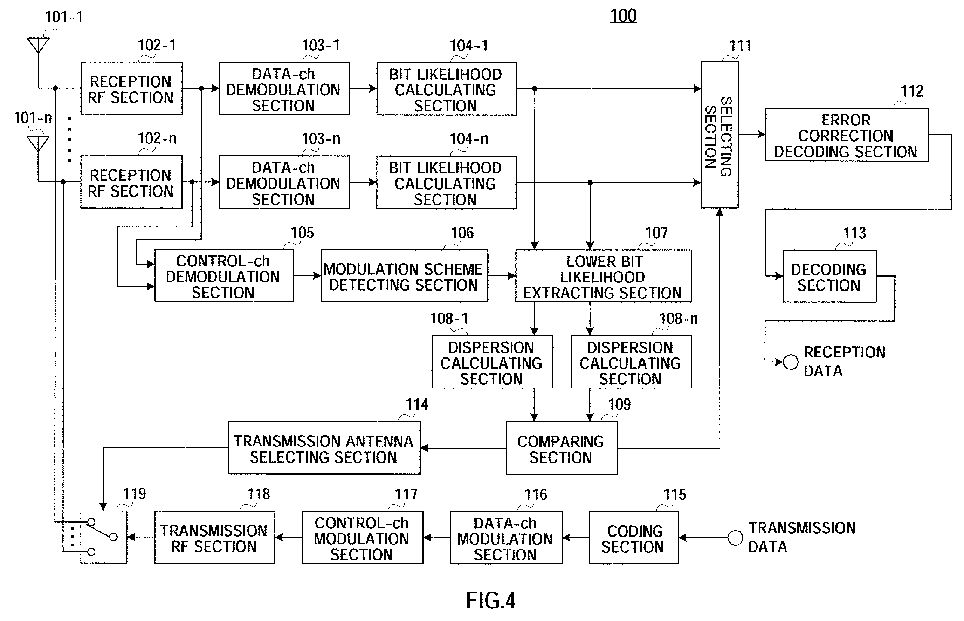

FIG.4 is a block diagram showing a configuration of radio communication apparatus 100 according to an embodiment of the present invention. Radio communication apparatus 100 can be provided in either a base station apparatus or communication terminal apparatus such as a mobile telephone. In this embodiment, it is assumed that radio communication apparatus 100 is provided and used in a base station apparatus. It is further assumed in this embodiment that radio communication is performed in a TDD (Time Division Duplex) scheme.

Radio communication apparatus 100 has a plurality of antenna elements 101-1 to 101-n, a plurality of reception radio frequency (RF) sections 102-1 to 102-n, a plurality of data channel (ch) demodulation sections 103-1 to 103-n, a plurality of bit likelihood calculating sections 104-1 to 104-n, control-ch demodulation section 105, modulation scheme detecting section 106, lower bit likelihood extracting section 107, a plurality of dispersion calculating sections 108-1 to 108-n, comparing section 109, selecting section 111, error correction decoding section 112, decoding section 113, transmission antenna selecting section 114, coding section 115, data-ch modulation section 116, control-ch modulation section 117, transmission RF section 118 and switch section 119.

A plurality of antenna elements 101-1 to 101-n receive modulated radio signals and input the signals to reception RF sections 102-1 to 102-n respectively, and, when switch section 119 inputs transmission signals, antenna elements 101-1 to 101-n transmit by radio the transmission signals.

A plurality of reception radio frequency (RF) sections 102-1 to 102-n, each having a band pass filter, analog/digital converter, low noise amplifier and the like, perform predetermined radio reception processing on received signals respectively inputted from antenna elements 101-1 to 101-n, and input the received signals respectively to data-ch demodulation sections 103-1 to 103-n and control-ch demodulation section 105.

A plurality of data channel (ch) demodulation sections 103-1 to 103-n demodulate the received signals inputted from reception RF sections 102-1 to 102-n with a demodulation scheme corresponding to a modulation scheme of data-ch of the received signals, and input demodulated received signals of data-ch to bit likelihood calculating sections 104-1 to 104-n.

A plurality of bit likelihood calculating sections 104-1 to 104-n perform soft decision for each symbol on the received signals inputted from data-ch demodulation sections 103-1 to 103-n, calculate the likelihood for each of antennas 101-1 to 101-n on all the bits included in each symbol, and input the calculated likelihood (hereinafter, referred to as "bit likelihood") of each bit and the received signals to lower bit likelihood extracting section 107 and selecting section 111 for each symbol.

Control-ch demodulation section 105 demodulates the received signals inputted from reception RF sections 102-1 to 102-n with a demodulation scheme corresponding to a modulation scheme of control-ch of the received signals, and inputs the demodulated received signals of control-ch to modulation scheme detecting section 106.

Modulation scheme detecting section 106 decodes the received signals of control-ch inputted from control-ch demodulation section 105, detects a modulation scheme of data-ch in the received signals, and reports the detected modulation scheme to lower bit likelihood extracting section 107.

Basedon the modulation scheme of data-ch reported from modulation scheme detecting section 106, lower bit likelihood extracting section 107 determines whether to extract only the bit likelihood of a least significant bit (LSB) or bit likelihood of the LSB and a second bit from the LSB out of bit likelihood for each symbol inputted from bit likelihood calculating sections 104-1 to 104-n. Then, according to the determination result, lower bit likelihood extracting section 107 extracts only the bit likelihood of the LSB or two bit likelihoods of two bits from the LSB out of the bit likelihood for each symbol inputted from bit likelihood calculating sections 104-1 to 104-n, and outputs the likelihood to dispersion calculating sections 108-1 to 108-n.

A plurality of dispersion calculating sections 108-1 to 108-n each stores the bit likelihood inputted from lower bit likelihood extracting section 107 for a predetermined period, and thereby calculates the dispersion of the bit likelihood for each of antenna elements 101-1 to 101-n. Then, dispersion calculating sections 108-1 to 108-n input the calculated dispersion of the bit likelihood to comparing section 109.

Comparing section 109 compares the dispersions of the bit likelihood inputted from dispersion calculating section 108-1 to 108-n with one another, ranks antenna elements 101-1 to 101-n in ascending order of the dispersion, and reports the ranks to selecting section 111 and transmission antenna selecting section 114.

According to the ranks of antenna elements 101-1 to 101-n reported from comparing section 109, selecting section 111 selects a predetermined number of received signals from the received signals inputted from bit likelihood calculating sections 104-1 to 104-n, and inputs the selected received signals to error correction decoding section 112. In other words, selecting section 111 selects a predetermined number of reception antenna elements in ascending order of the dispersion of the bit likelihood.

Error correction decoding section 112 performs hard decision on the received signals inputted from selecting section 111, performs error correction decoding on the received signals subjected to hard decision with a predetermined scheme, and inputs the results to decoding section 113.

Decoding section 113 decodes the received signals inputted from error correction decoding section 112 with a predetermined scheme to generate reception data, and inputs the generated reception data to a baseband section (not shown) and the like.

According to the ranks of antenna elements 101-1 to 101-n reported from comparing section 109, transmission antenna selecting section 114 selects a predetermined number of antenna elements as transmission antenna elements, and reports the selection result to switch section 119.

Coding section 115 codes transmission data inputted from the baseband section (not shown) and the like with a predetermined scheme to generate transmission signals, and inputs the generated transmission signals to data-ch modulation section 116.

Data-ch modulation section 116 modulates the transmission signals inputted from coding section 115 with a predetermined scheme, and inputs the modulated transmission signals to control-ch modulation section 117.

Control-ch modulation section 117 modulates a signal indicating the modulation scheme of the transmission signals inputted from data-ch modulation section 116 with a predetermined scheme, and adds the modulated signal indicating the modulation scheme to the transmission signals inputted from data-ch modulation section 116 as a control-ch signal. Then, data-ch modulation section 116 inputs the transmission signals with the control-ch signal added, to transmission RF section 118.

Transmission RF section 118 has a band pass filter, digital/analog converter, low noise amplifier and the like, performs predetermined radio transmission processing on the transmission signals inputted from control-ch modulation section 117, and inputs the transmission signals to switching section 119.

According to the report from transmission antenna selecting section 114, switching section 119 inputs the transmission signals inputted from transmission RF section 118 to the antenna elements selected by transmission antenna selecting section 114.

Next, the operation of radio communication apparatus 100 will be described.

FIG.5 shows an example of a frame configuration of a radio signal used in this embodiment. In FIG.5, "↑" indicates an uplink slot, and "↓" indicates a downlink slot. In this embodiment, as shown in FIG.5, radio communication apparatus 100 calculates the dispersion of the bit likelihood of a received signal in the first uplink slot, selects antenna elements with good reception quality, and transmits the transmission signal in an immediately subsequent downlink slot using the subsequently selected antenna elements. Therefore, according to radio communication apparatus 100, it is possible to implement adaptive transmission diversity.

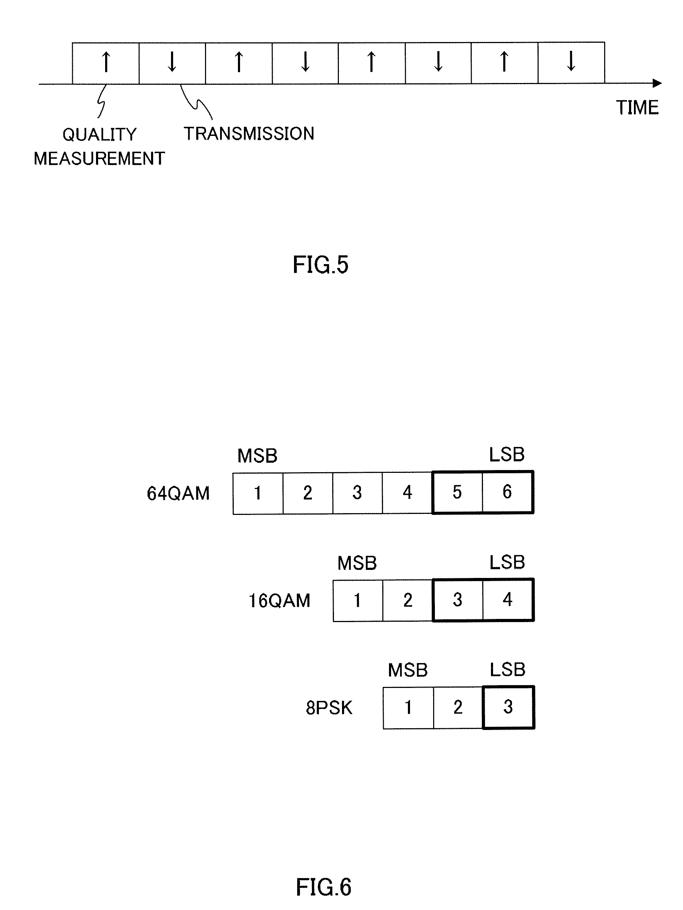

FIG.6 shows bit configurations of one symbol of a received signal modulated with each of 64QAM, 16QAM and8PSK. In FIG. 6, bit numbers are assigned sequentially to bits from the most significant bit (MSB) to the LSB of each received signal, starting with "1". Herein, since the received signal modulated with the quadrature phase amplitude modulation scheme such as 64QAM and 16QAM is made up of an in-phase component (I component) and a quadrature component (Q component), the likelihood for a bit before the LSB is calculated in the same way as for the LSB. More specifically, in 64QAM, bit number 5 is the LSB of the I component, and bit number 6 is the LSB of the Q component. Meanwhile, in 16QAM, bit number 3 is the LSB of the I component, and bit number 4 is the LSB of the Q component. Therefore, one reference explained using FIG.3 is applied to calculation of the likelihood of each of the LSB of the I component and LSB of the Q component.

Accordingly, when lower bit likelihood extracting section 107 extracts the bit likelihood of the LSB of the I component and the bit likelihood of the LSB of the Q component of the received signal modulated with the quadrature phase amplitude modulation scheme, that is, bit likelihood of twobits (hereinafter, referred to as "two lower bits" as appropriate) from the LSB, it is possible to prevent formation of two peaks as shown in FIGs . 2A to 2c in the distribution mode of the likelihood of the received signal. Further, regarding the received signal modulated with a phase modulation scheme of eight or more values such as 8PSK, lower bit likelihood extracting section 107 extracts only the bit likelihood of the LSB, and it is thereby possible to prevent the dispersion of the likelihood of the received signal from spreading.

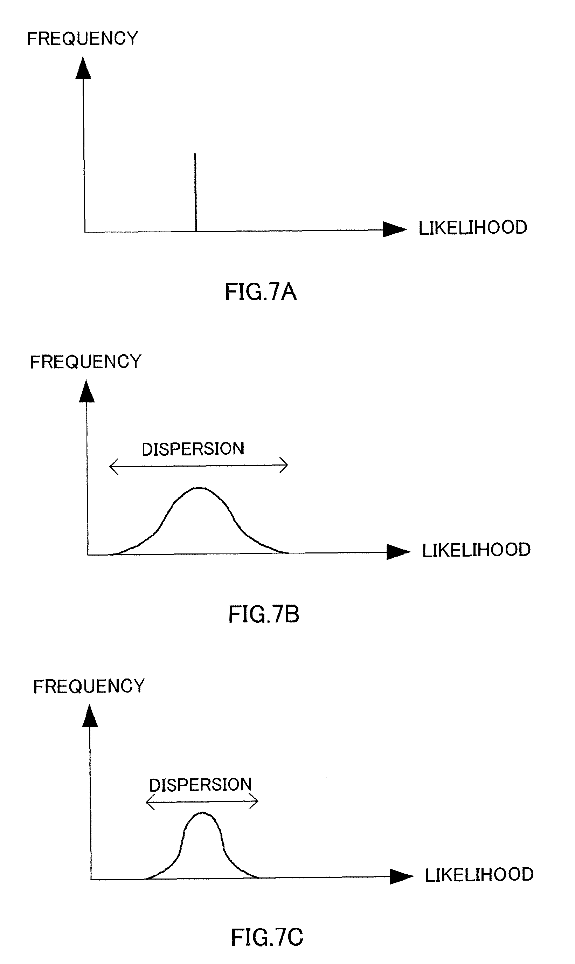

FIGs.7A to 7C show distribution modes of the likelihood of the two lower bits of the received signal modulated with 16QAM. FIG.7A shows the distribution mode of the likelihood of the two lower bits of the received signal in an ideal state that noise, interference signals and delay versions are not included at all. As can be seen from FIG. 7A, any dispersion occurs in the likelihood of the two lower bits of the received signal in such an ideal reception state. Actually, dispersions as shown in FIGs.7B and 7C occur in the likelihood of the two lower bits. However, the level of the dispersion directly corresponds to the reception quality for each antenna element, and therefore, based on the dispersion, radio communication apparatus 100 can select an antenna element with good reception quality from antenna elements 101-1 to 101-n. For example, when the dispersion (FIG.7C) of the likelihood of the two lower bits of the received signal at antenna element 101-2 is smaller than the dispersion (FIG.7B) of the likelihood of the two lower bits of the received signal at antenna element 101-1, radio communication apparatus 100 selects antenna element 101-2 with better reception quality.

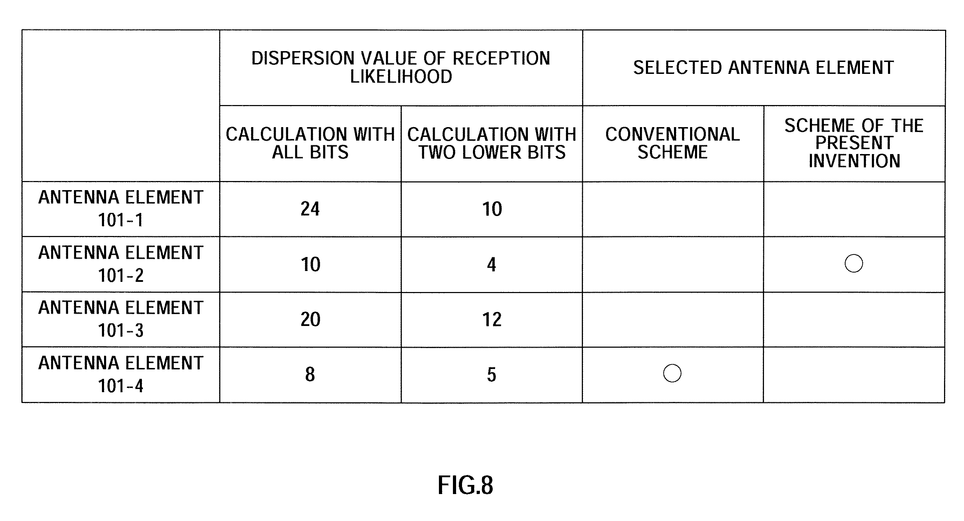

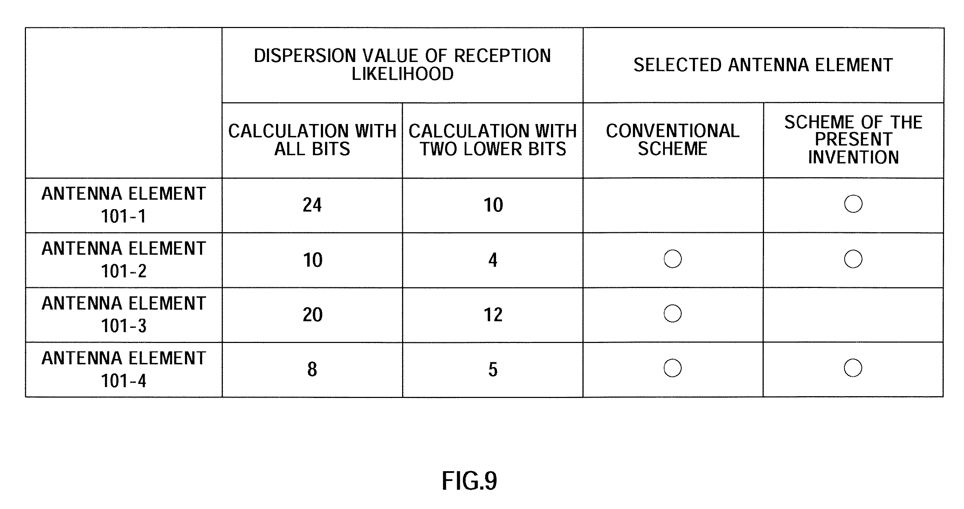

FIGs.8 and 9 show results of simulating which antenna elements transmission antenna selecting section 114 selects from antenna elements 101-1 to 101-n, in the case (conventional scheme) of calculating the dispersion of the bit likelihood for each symbol (likelihood of all the bits of a symbol) and in the case (scheme of the present invention) of calculating the dispersion of the bit likelihood of the two lower bits, regarding signals modulated with 16 QAM received at antenna elements 101-1 to 101-n. FIG. 8 shows the case where transmission antenna selecting section 114 selects a single antenna element 101 with the best reception quality, and FIG.9 shows the case where transmission antenna selecting section 114 selects three antenna elements 101 in descending order of the reception quality. As can be seen from FIGs. 8 and 9, according to this embodiment, unlike the conventional scheme, antenna elements with good reception quality are appropriately selected.

Thus, according to this embodiment, in the case of receiving a radio signal at antenna elements 101-1 to 101-n, dispersion calculating sections 108-1 to 108-n each calculates the likelihood of two bits or less from the LSB in the received signal, so that it is possible to prevent the dispersion of the likelihood from spreading, and as a result, accurately obtain each reception quality of antenna elements 101-1 to 101-n. As a result, the error rate of the received signal can be improved.

Further, according to this embodiment, radio communication apparatus 100 transmits a radio signal in a transmission slot from an antenna element selected in a reception slot immediately before the transmission slot, so that it is possible to perform transmission diversity adaptively.

In addition, radio communication apparatus 100 according to this embodiment may be modified and/or applied as described below.

In this embodiment, the case has been described where lower bit likelihood extracting section 107 calculates the dispersion of the likelihood of the two lower bits of the received signal modulated with the quadrature phase amplitude modulation scheme, but the present invention is not limited to this case. For example, lower bit likelihood extracting section 107 may calculate the dispersion of the likelihood only of the LSB in the received signal modulated with the quadrature phase amplitude modulation scheme. In this way, it is also possible to prevent the dispersion of the likelihood of the received signal from spreading.

Further, in this embodiment, the case has been described where radio communication apparatus 100 is provided in the base station apparatus, but the present invention is not limited to this case. For example, radio communication apparatus 100 may be provided in a communication terminal apparatus such as a mobile telephone. Furthermore, radio communication apparatuses 100 may be provided in both the base station apparatus and communication terminal apparatus and perform radio communication in a TDD scheme in a radio communication system including these apparatuses.

In addition, radio communication apparatus 100 may perform radio communication in an OFDM (Orthogonal Frequency Division Multiplexing) scheme.

Further, in this embodiment, the example has been shown where antennas are targeted for selection, the present invention may be used to select subcarriers in OFDM. Furthermore, the present invention may be used to select streams in MIMO.

Moreover, in this embodiment, the case has been described as an example where the present invention is implemented with hardware, but the present invention may be implemented with software.

Furthermore, each function block used to explain this embodiments is typically implemented as an LSI constituted by an integrated circuit. These may be individual chips or may partially or totally contained on a single chip. Furthermore, here, each function block is described as an LSI, but this may also be referred to as "IC", "system LSI", "super LSI", "ultra LSI" depending on differing extents of integration.

Further, the method of circuit integration is not limited to LSI's, and implementation using dedicated circuitry or general purpose processors is also possible. After LSI manufacture, utilization of a programmable FPGA (Field Programmable Gate Array) or a reconfigurable processor in which connections and settings of circuit cells within an LSI can be reconfigured is also possible.

Further, if integrated circuit technology comes out to replace LSI's as a result of the development of semiconductor technology or a derivative other technology, it is naturally also possible to carry out function block integration using this technology.

### Application in biotechnology is also possible.

The present application is based on Japanese Patent Application No.2004-140969 filed on May 11, 2004, entire content of which is expressly incorporated by reference herein.

### Industrial Applicability

The present invention has an advantage of capable of preventing the dispersion of the likelihood of a received signal from spreading, consequently obtaining the reception quality for each antenna element more accurately and further improving the error rate of the received signal in the case of performing antenna selective diversity, and is useful particularly in a base station apparatus performing high-speed radio communication, radio terminal apparatus such as a mobile telephone, and the like.

## Claims

1. A radio communication apparatus comprising:
a plurality of antenna elements;
a calculating section that calculates dispersion of a likelihood for each of the plurality of antenna elements on a part of lower bit of a signal received at each of the plurality of antenna elements; and
a selecting section that selects the antenna element in ascending order of the dispersion.

2. The radio communication apparatus according to claim 1, wherein the calculating section calculates the dispersion on the part of lower bit where the likelihood is calculated on the same reference among a plurality of symbols in a constellation.

3. The radio communication apparatus according to claim 1, wherein the calculating section calculates the dispersion on the part of lower bit with the number of bits corresponding to a modulation scheme of the signal.

4. The radio communication apparatus according to claim 1, wherein the calculating section calculates the dispersion of the likelihood of two lower bits of the signal or the dispersion of the likelihood of the least significant bit of the signal when the modulation scheme of the signal is 16QAM or 64QAM.

5. The radio communication apparatus according to claim 1, wherein the calculating section calculates the dispersion of the likelihood of the least significant bit of the signal when the modulation scheme of the signal is 8PSK.

6. The radio communication apparatus according to claim 1, further comprising a transmission section that transmits a signal using a transmission slot from a the antenna element selected by the selecting section,
wherein the selecting section selects the antenna element using a reception slot immediately before the transmission slot.

7. A radio communication system comprising the radio communication apparatus according to claim 1.
